# EUROPEAN PATENT APPLICATION

(11) **EP 0 899 792 A2**
(43) Date of publication of application: **03.03.1999**
(21) Application number: 98116101.1
(22) Date of filing: 26.08.1998
(51) Int. Cl.: H01L 29/78, H01L 21/336

(54) **Transistor with structured sidewalls and method**

(30) Priority: 26.08.1997 US 56960 P
(71) Applicant: Texas Instruments Incorporated, Dallas, Texas 75251 (US)
(72) Inventor: Johnson, Frank Scott, Richardson, Texas 75080 (US)
(74) Representative: Schwepfinger, Karl-Heinz, Dipl.-Ing.

(57) **Abstract**

A transistor and method of construction are described that comprises composite sidewall spacer bodies 20 and 22. Bodies 20 and 22 are formed using a silicon nitride layer 16 and a silicon dioxide layer 18. Bodies 20 and 22 are disposed on opposite sidewalls of a gate conductor body 14 which is separated from a semiconductor substrate 10 by a gate insulator layer 12. Sidewall bodies 20 and 22 provide the controllable and robust characteristics of silicon nitride, but do not require the formation of a thick silicon nitride layer which might result in the migration of unwanted impurities into the substrate 10 from the conductor body 14.

## Description

### TECHNICAL FIELD OF THE INVENTION

This invention relates in general to the field of transistors, and more particularly to a transistor and method of construction having a composite sidewall spacer structure.

### BACKGROUND OF THE INVENTION

In the construction of MOS transistors, sidewall spacers are often constructed on opposite sidewalls of the gate conductor. These sidewall spacers allow for the more controlled and efficient formation of the source and drain regions on opposite sides of the gate conductor. It is important to the positioning of the source and drain regions for the width of the sidewall spacer to be a dimension that is easily and accurately controlled. In the past, the sidewall spacers have been formed of silicon dioxide. This process typically involves the deposition of a conformal layer of silicon dioxide over the preformed gate conductor. This layer of silicon dioxide is then etched anisotropically until only small filaments remain proximate the opposing vertical sidewalls of the gate conductor. The process used to etch the silicon dioxide layer is typically a plasma process involving reactive ion etching. This process can do unacceptable damage to the surface of the substrate where the source and drain regions will be positioned. In addition, any later deglazing etches used to remove native oxides from the surface of the gate or the surface of the silicon substrate itself will also attack the sidewall insulators. Deglazing operations are typically wet etch processes which are difficult to control in both their intensity and duration. For this reason, the sidewall spacer structures are etched in these processes to an unknown degree creating manufacturability problems and yield problems.

The problems with the use of silicon dioxide as the sidewall spacer have been partially addressed through the use of silicon nitride sidewall spacers. The use of silicon nitride enables the surface of the substrate to remain covered by the gate oxide during the formation of the silicon nitride spacer bodies. This is because etched processes are available that are highly selective between nitride and oxide. As such, deglazing operations and implant procedures can proceed without damage to the surface or the substrate or damage to the nitride spacer bodies themselves. However, the use of silicon nitride creates new problems. It can only be deposited at extremely slow deposition rates at relatively high temperatures. For example, a silicon nitride layer of the order of 2,000 Angstroms in thickness would require a deposition temperature on the order of 800° Centigrade and a deposition time in excess of 2 hours. This lengthy process creates serious throughput difficulties. In addition, the high thermal budget of this process allows impurities within the gate conductor itself, especially boron, to diffuse through the thin gate oxide into the semiconductor substrate where the channel of the transistor is to be formed. These impurities can cause detrimental shifts in the threshold voltage of the transistor.

Accordingly, a need has arisen for a sidewall spacer structure that allows for the protection of the surface of the semiconductor substrate but does not negatively impact the threshold voltage of the device or the throughput of the manufacturing of the device.

### SUMMARY OF THE INVENTION

In accordance with the teachings disclosed herein, a transistor architecture having a composite sidewall structure is provided that substantially eliminates disadvantages and problems associated with prior structures and methods of formation.

In accordance with a first described embodiment a transistor formed on an outer surface of a semiconductor layer is provided that comprises a gate conductor body having opposing sidewalls disposed proximate an outer surface of the semiconductor layer. A gate insulator layer is disposed between the outer surface of the semiconductor layer and the gate conductor body. First and second sidewall insulator bodies are disposed proximate opposing sidewalls of the gate conductor body and adjacent to portions of the outer surface of the semiconductor layer proximate the opposing sidewalls of the gate conductor body. Each of the sidewall insulator bodies comprises a first layer of silicon nitride adjacent to the sidewall of the gate conductor body and to the surface of the semiconductor layer and a silicon dioxide layer adjacent to the silicon nitride layer and separated from the gate conductor body and the surface of the semiconductor layer by the silicon nitride layer.

### BRIEF DESCRIPTION OF THE DRAWINGS

The present invention will now be further described, by way of example, with reference to the accompanying drawings in which:

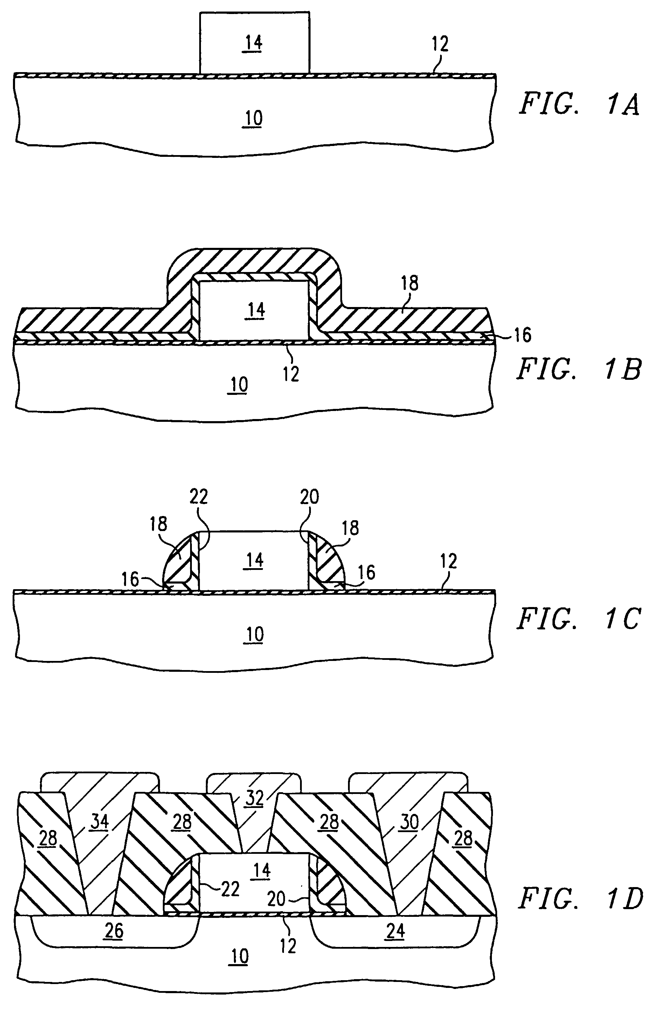

FIGURES 1A-1D are a series of greatly enlarged, cross-sectional, elevational, schematic diagrams illustrating a method of forming a transistor having composite sidewall spacer bodies.

### DETAILED DESCRIPTION OF THE INVENTION

FIGURES 1A-1D illustrate a series of processes that can be used to form a transistor having composite sidewall spacer structures. Referring to FIGURE 1A, a semiconductor substrate 10 is shown that may comprise, for example, silicon, gallium arsenide, or other suitable semiconductor material. A gate insulator layer 12 is formed on an outer surface of substrate 10. Gate insulator layer 12 may comprise a layer of silicon dioxide of the order of 50 to 60 Angstroms in thickness. A gate conductor body 14 is disposed outwardly from a portion of the surface of gate insulator layer 12. Gate conductor body 14 may comprise, for example, polycrystalline silicon and may be on the order of 2000 to 4000 Angstroms in thickness and on the order of 2500 Angstroms in width. It should be understood that the structures shown in FIGURES 1A-1D are presented solely for the purposes of illustration and in some instances, will not be shown in proper scale.

Gate conductor body 14 may be constructed by depositing a layer of polycrystalline semiconductor materials and patterning and etching the deposited layer using conventional photolithographic processes. Gate conductor body 14 may also be implanted with P-type impurities such as boron or N-type impurities such as arsenic or phosphorous to render the gate conductor more conductive. In later processing steps, these impurities, especially boron, may migrate across gate insulator layer 12 into the region of substrate 10 immediately proximate to the gate conductor body 14. If these impurities are allowed to migrate into this area, the ultimate threshold voltage of the completed device can be detrimentally affected. The migration of these impurities takes place when the implanted gate conductor 14 is subjected to high temperature for a long period of time. As such, later processes must involve only low temperature processes or restrict the amount of time that high temperature processes are used.

Referring to FIGURE 1B, a silicon nitride layer 16 is deposited covering the exposed portions of gate insulator layer 12 and the entirety of gate conductor body 14. Silicon nitride layer 16 may be deposited using low pressure chemical vapor deposition. Layer 16 may be of the order of 250 Angstroms in thickness. While this process particularly requires temperatures of 800° Centigrade, a layer of only 250 Angstroms in thickness means that the structure will only be subjected to such high temperatures for of the order of 10 to 12 minutes. This is not a sufficient time for boron or other impurities within gate conductor body 14 to diffuse in any substantial amount across the gate insulator layer 12 into the substrate 10. An additional thin layer of silicon dioxide may be deposited immediately before the deposition of silicon nitride layer 16.

A silicon dioxide layer 18 is then deposited outwardly from silicon nitride layer 16. Silicon dioxide layer 18 may also be deposited using low pressure chemical vapor deposition. Layer 18 may be of the order of 1,750 Angstroms in thickness. This deposition process occurs at a temperature of the order of 600 to 700° Centigrade. Because the diffusion of impurities within the gate conductor body 14 is proportional to e^{-1/T}, there will be little diffusion of the impurities, especially boron, out of the gate conductor body 14 during the formation of layer 18.

FIGURE 1C illustrates the cross-sectional structure including composite sidewall spacer bodies 20 and 22 on opposite sidewalls of gate conductor body 14. Bodies 20 and 22 are formed using two successive etch processes. First, the silicon dioxide layer 18 is etched using a process which is highly selective to silicon dioxide relative to silicon nitride. This etch process can use a variety of suitable reactive ion etching systems and can achieve in excess of 10:1 selectivity and a high degree of anisotropy. In addition, end point detectors operable to detect the presence of silicon nitride can be used as an etch stop for the process. For example, a plasma etch may be used that utilizes Chlorine, Bromine or Helium and a Fluorine source such as CF₄ or SF₆. The ratios of these reactants can be changed to provide the appropriate selectivity. A second etch process is then used to etch the exposed portions of silicon nitride layer 16. Similarly, this etch process can utilize suitable etch processes that are highly selective to silicon nitride relative to silicon dioxide and polysilicon and can use end point detectors to detect polysilicon or silicon dioxide as etch stops. For example, a plasma etch may be used that utilizes Chlorine, Bromine or Helium and a Fluorine source such as CF₄ or SF₆. The ratios of these reactants can be changed to provide the appropriate selectivity. After these two processes are completed, the outer surface of gate insulator layer 12 and the outer surface of gate conductor body 14 will be exposed and the sidewall bodies 20 and 22 will remain. If layer 16 is of the order of 250 Angstroms in thickness and layer 18 is of the order of 1750 Angstroms in thickness, sidewall bodies 20 and 22 will be of the order of 1750 Angstroms in width at the foot of each of the bodies proximate the outer surface of gate insulator layer 12. Sidewall bodies 20 and 22 are highly durable with respect to later deglazing processes. In addition, the structure maintains some amount of oxide covering the outer surface of substrate 10 to protect the surface of substrate 10 from ion bombardment during the etch processes. In addition, the remaining portions of insulator layer 12 help in the implantation of source and drain regions as they prevent the contamination of the substrate 10 from metallic ions inadvertently created during the implantation process used to create the source and drain regions. It should be understood that layers 16 and 18 need not comprise silicon dioxide and silicon nitride, but rather, may comprise any suitable dielectrics that can be selectively etched with respect to one another.

FIGURE 1D illustrates the completed device, including sidewall insulator spacer bodies 20 and 22. FIGURE 1D illustrates the placement of source region 24 and drain region 26. In addition, an isolation insulator layer 28 comprising, for example, silicon dioxide has been deposited. In addition, a source contact 30, a gate contact 32, a drain contact 34 have been formed to allow electrical access to three nodes of the transistor formed. It should be understood that FIGURE 1D illustrates a simplified version of a transistor. The device may include other layers, for example, titanium silicide layers may also be included to reduce contact resistance at the source drain and gate regions.

Although illustrative embodiments of the present invention have been described in detail, it should be understood that various changes, alterations, substitutions and modifications may be made to the teachings contained herein without departing from the spirit and scope of the present invention.

## Claims

1. A transistor, comprising:
a gate conductor body having opposing sidewalls disposed proximate a surface of the semiconductor layer;
a gate insulator layer disposed between the surface of the semiconductor layer and the gate conductor body;
first and second sidewall insulator bodies each disposed proximate one of the opposing sidewalls of the gate conductor body and adjacent to portions of the surface of the semiconductor layer proximate the opposing sidewalls of the gate conductor body; and
each of the sidewall insulator bodies comprising a first layer of silicon nitride adjacent to the sidewall of the gate conductor body and to the surface of the semiconductor layer and a silicon dioxide layer adjacent to the silicon nitride layer and separated from the gate conductor body and the surface of the semiconductor layer by the silicon nitride layer.

2. The transistor of Claim 1 wherein the gate insulator layer comprises silicon dioxide.

3. The transistor of Claim 1, wherein the gate conductor body comprises polycrystalline silicon.

4. The transistor of any of Claims 1 to 3, wherein the gate insulator layer is of the order of 60 Angstroms in thickness, the gate conductor body is of the order of 2500 Angstroms in width and the sidewall insulator bodies are each of the order of 1750 Angstroms in width.

5. A method of forming a transistor comprising the steps of:
forming a gate conductor body having opposing sidewalls disposed proximate a surface of the semiconductor layer;
forming a gate insulator layer disposed between the outer surface of the semiconductor layer and the gate conductor body;
forming first and second sidewall insulator bodies each disposed proximate one of the opposing sidewalls of the gate conductor body and adjacent to portions of the outer surface of the semiconductor layer proximate the opposing sidewalls of the gate conductor body; and
each of the sidewall insulator bodies formed from a first layer of silicon nitride deposited adjacent to the sidewall of the gate conductor body and to the surface of the semiconductor layer and a silicon dioxide layer deposited adjacent to the silicon nitride layer and separated from the gate conductor body and the surface of the semiconductor layer by the silicon nitride layer.

6. The method of Claim 5, wherein the step of forming the gate insulator layer comprises the step of growing a layer of silicon dioxide.

7. The method of Claim 5 or Claim 6, wherein the step of forming the gate conductor body comprises the steps of depositing a layer of polycrystalline silicon and patterning and etching the polycrystalline silicon layer.

8. The method of any of Claims 5 to 7, wherein the steps of forming the gate insulator layer, the gate conductor body and the sidewall insulator bodies comprise forming a gate insulator layer of the order of 60 Angstroms in thickness, a gate conductor body of the order of 2500 Angstroms in width and a sidewall insulator bodies each of the order of 1750 Angstroms in width.

9. The method of any of Claims 5 to 8, wherein the step of forming first and second sidewall insulator bodies comprises the steps of:
depositing a layer of silicon nitride over the gate conductor body and portions of the gate insulator layer;
depositing a layer of silicon dioxide over the layer of silicon nitride;
etching the layer of silicon dioxide using an isotropic etch process that is selective to silicon dioxide relative to silicon nitride; and
etching the layer of silicon nitride using an isotropic etch process that is selective to silicon nitride relative to silicon dioxide.
